# EUROPEAN PATENT APPLICATION

(11) **EP 3 343 606 A1**
(43) Date of publication of application: **04.07.2018**
(21) Application number: 17210421.8
(22) Date of filing: 22.12.2017
(51) Int. Cl.: H01L 23/473

(54) **COOLING DEVICE**

(30) Priority: 28.12.2016 JP 2016254595
(71) Applicant: Mitsubishi Jidosha Engineering Kabushiki Kaisha, Aichi 444-8501 (JP); Mitsubishi Jidosha Kogyo Kabushiki Kaisha, Tokyo 108-8410 (JP)
(72) Inventor: ANDO, Toshihiko, Okasaki-shi, Aichi 444-8501 (JP); HORIBE, Shinsuke, Tokyo, 108-8410 (JP); ISHIKAWA, Kiyotaka, Tokyo, 108-8410 (JP)
(74) Representative: Regimbeau

(57) **Abstract**

An object is to cool electrical components mounted to an automobile efficiently. A cooling device (1) for cooling a first member (2, 4) and a second member (3, 5), includes: a cooling medium flow passage (R) which is formed between the first member (2, 4) and the second member (3, 5), and through which a cooling medium for cooling the first member (2, 4) and the second member (3, 5) flows; and a swirl generation enhancing portion (51, 52, 53) disposed in the cooling medium flow passage (R) and configured to enhance generation of a swirl of the cooling medium flowing therein.

## Description

### TECHNICAL FIELD

The present disclosure relates to a cooling device for cooling electrical components mounted to an automobile.

### BACKGROUND

Various electrical components such as an inverter are mounted to an automobile. Such electrical components generate heat by being supplied with electric current, and thus an automobile is equipped with a cooling device for cooling the electrical components. In particular, electrical components mounted to an electric vehicle (e.g. inverter for a driving motor) generates a large amount of heat, and thus such an electric vehicle is required to have a cooling device with a high cooling capacity.

### SUMMARY

For instance, Patent Document 1 (WO2012/029165A) relates to a semiconductor module constituting an inverter for a driving motor used in a hybrid vehicle or an electric vehicle, and discloses mounting a cooling plate portion with a fin to the semiconductor. Furthermore, Patent Document 1 (WO2012/029165A) discloses cooling the semiconductor module via the cooling plate portion (fin) by letting a cooling medium flow through a cooling medium flow passage formed by the cooling plate portion and a flow-passage forming member.

However, in the cooling medium flow passage disclosed in Patent Document 1 (WO2012/029165A), the fin is disposed in a space where the cooling medium has a high flow resistance, and thus the flow volume of the cooling medium in the space with the fin is smaller than the flow volume of the cooling medium in the space without the fin. That is, the technique disclosed in Patent Document 1 (WO2012/029165A) cannot efficiently cool the fin (semiconductor module) with the cooling medium.

The present invention was made in view of the above problem, and an object of at least one embodiment of the present invention is to cool electrical components mounted to an automobile efficiently.

A cooling device according to at least one embodiment of the present invention is for cooling a first member and a second member, and the cooling device includes: a cooling medium flow passage which is formed between the first member and the second member, and through which a cooling medium for cooling the first member and the second member flows; and a swirl generation enhancing portion disposed in the cooling medium flow passage and configured to enhance generation of swirls of the cooling medium flowing therein.

With the above configuration, it is possible to enhance generation of swirls flow of the cooling medium with the swirl generation enhancing portion, and to make the cooling medium flow efficiently, thereby cooling the first member and the second member efficiently.

### BRIEF DESCRIPTION OF DRAWINGS

FIG. 1 is a schematic perspective view of the structure of a cooling device according to an embodiment.
FIG. 2 is a schematic perspective view of the structure of a cooling device according to an embodiment.
FIG. 3 is a vertical cross-sectional view of the structure of a cooling device according to an embodiment (taken along lines III-III in FIGs. 1 and 2).
FIG. 4 is vertical cross-sectional view of a modification example showing a modified structure of a cooling device according to an embodiment.
FIG. 5 is vertical cross-sectional view of a modification example showing a modified structure of a cooling device according to an embodiment.

### DETAILED DESCRIPTION

Embodiments of a cooling device according to the present invention will now be described in detail with reference to the accompanying drawings. It will be understood that the present invention is not limited to the following embodiment and may be modified in various ways within the scope of the present invention.

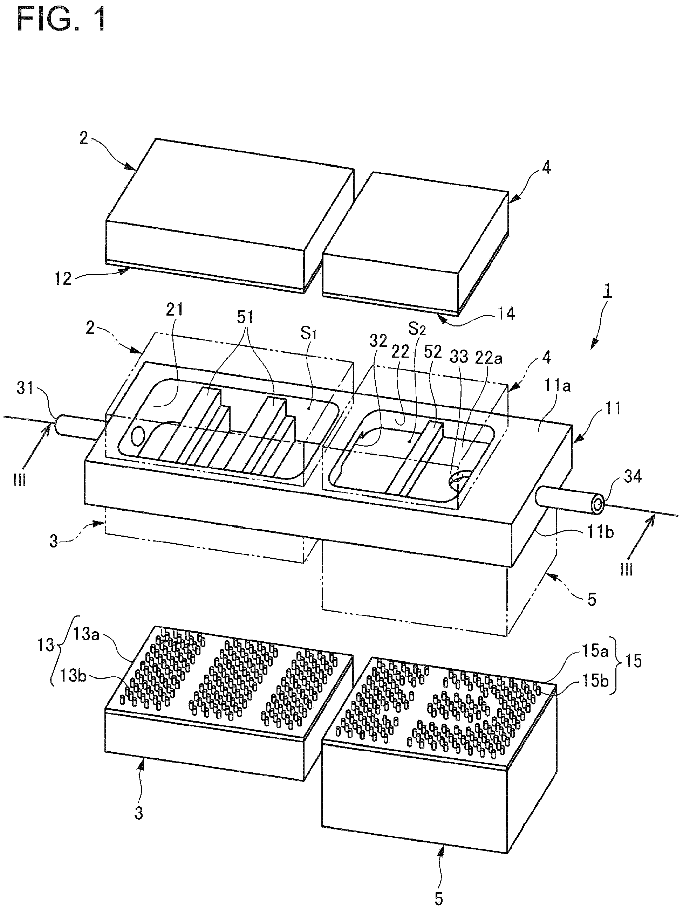

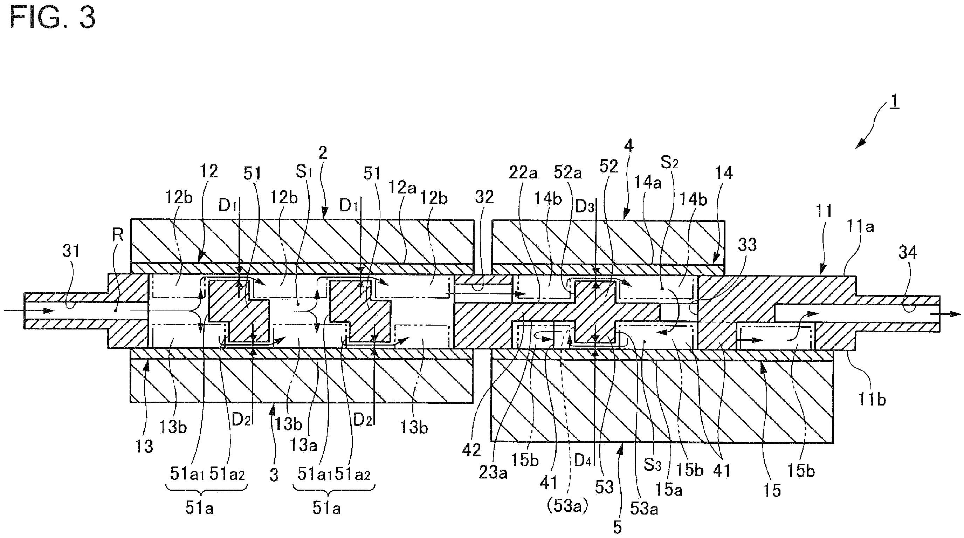

With reference to FIGs. 1 and 3, the structure of a cooling device according to an embodiment of the present invention will now be described.

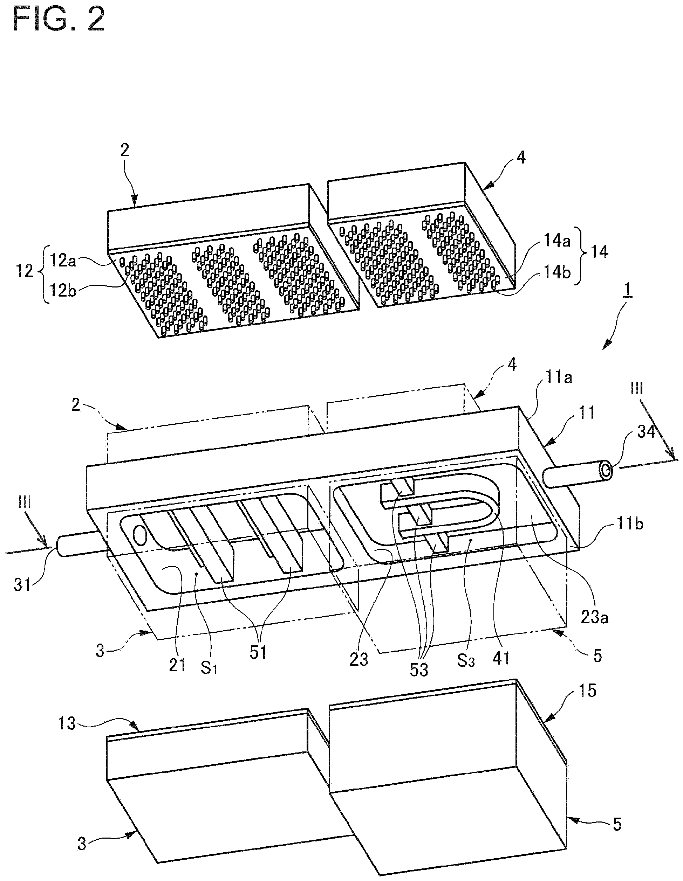

As shown in FIGs. 1 and 2, the cooling device 1 includes a cooling medium flow-passage forming member 11 having a substantially plate shape, made of aluminum. The first member 2, the second member 3, the third member 4, and the fourth member 5, which are electrical components to be cooled, are attachable to the cooling medium flow-passage forming member 11.

Herein, the first member 2 and the third member 4 are disposed on a surface 11a (upper surface; the upper surface in FIG. 1) of the cooling medium flow-passage forming member 11, next to each other along the longitudinal direction of the cooling medium flow-passage forming member 11, and the second member 3 and the fourth member 5 are disposed on the other surface 11b (lower surface; the lower surface in FIG. 1) of the cooling medium flow-passage forming member 11, next to each other along the longitudinal direction of the cooling medium flow-passage forming member 11.

FIG. 1 is a schematic perspective view of the cooling device 1 as seen from above obliquely, and FIG. 2 is a schematic perspective view of the cooling device 1 as seen from below obliquely. In FIGs. 1 and 2, to show the structure of the cooling medium flow-passage forming member 11 and the first member 2 to the fourth member 5 clearly, the first member 2 to the fourth member 5 before attached to the cooling medium flow-passage forming member 11 are shown in solid lines, and the first member 2 to the fourth member 5 after attached to the cooling medium flow-passage forming member 11 are shown in double-dotted chain lines.

Furthermore, the first member and the second member in the claims of the present invention correspond to the first member 2 and the second member 3, or the third member 4 and the fourth member 5 in the present embodiment.

Furthermore, the first cooling space on the side of the first member in the claims of the present invention corresponds to the second cooling space S₂ in the present embodiment, and the second cooling space on the side of the second member in the claims of the present invention corresponds to the third cooling space S₃ in the present embodiment.

As shown in FIGs. 1 and 2, the first heatsink 12, the second heatsink 13, the third heatsink 14, and the fourth heatsink 15 are mounted to the first member 2 to the fourth member 5, respectively, at the side attached to the cooling medium flow-passage forming member 11. The first heatsink 12 to the fourth heatsink 15 include: bodies 12a, 13a, 14a, 15a having a plate shape and the substantially same area as the first member 2 to the fourth member 5; and a plurality of cooling fins 12b, 13b, 14b, 15b protruding toward the cooling medium flow-passage forming member 11 from the bodies 12a to 15a.

As shown in FIGs. 1 to 3, the cooling medium flow-passage forming member 11 has a through hole 21 penetrating in an up-down direction (having openings on the upper surface 11a and the lower surface 11b) and disposed on the first side with respect to the longitudinal direction. The through hole 21 has an area slightly smaller than the first heatsink 12 and the second heatsink 13, and the first member 2 (first heatsink 12) and the second member 3 (second heatsink 13) are attached from the up-down direction so as to close the through hole 21.

Thus, a space (first cooling space) S₁ is formed in the cooling device 1, surrounded by the cooling medium flow-passage forming member 11 (through hole 21), the first member 2 (first heatsink 12), and the second member 3 (second heatsink 13).

In FIG. 3, the cooling fins 12b to 15b of the first heatsink 12 to the fourth heatsink 15 are simplified (shown by double-dotted chain line squares) for clarity.

Furthermore, as shown in FIGs. 1 to 3, the cooling medium flow-passage forming member 11 has an upper recess section 22 having an opening on the upper surface 11 a, disposed on the second side with respect to the longitudinal direction, and a lower recess section 23 having an opening on the lower surface 11b, disposed on the second side with respect to the longitudinal direction. The upper recess section 22 has an area slightly smaller than the third heatsink 14, and the third member 4 (third heatsink 14) is attached from above so as to close the upper recess section 22. Furthermore, the lower recess section 23 has an area slightly smaller than the fourth heatsink 15, and the fourth member 5 (fourth heatsink 15) is attached from below so as to close the lower recess section 23.

Thus, a space (second cooling space) S₂ and a space (third cooling space) S₃ are formed in the cooling device 1. The space S₂ is surrounded by the cooling medium flow-passage forming member 11 (upper recess section 22) and the third member 4. The space S₃ is surrounded by the cooling medium flow-passage forming member 11 (lower recess section 23) and the fourth member 5.

Furthermore, as shown in FIGs. 1 to 3, the cooling medium flow-passage forming member 11 has: a cooling medium supply port 31 that brings the outside and the first cooling space S₁ into communication; a first cooling medium communication port 32 that brings the first cooling space S₁ and the second cooling space S₂ into communication; a second cooling medium communication port 33 that brings the second cooling space S₂ and the third cooling space S₃ into communication; and a cooling medium discharge port 34 that brings the third cooling space S₃ and the outside in to communication.

Thus, in the cooling device 1, the cooling medium flow-passage forming member 11 and the first member 2 to the fourth member 5 (first heat sink 12 to fourth heatsink 15) form a cooling medium flow passage R (including the first cooling space S₁ to the third cooling space S₃) through which a cooling medium flows, and the cooling medium flowing through the cooling medium flow passage R cools the first heatsink 12 to the fourth heatsink 15, i.e., the first member 2 to the fourth member 5, which are disposed facing the cooling medium flow passage R.

Herein, as shown in FIGs. 2 and 3, the lower recess section 23 (third cooling space S₃) has a guide wall 41 for guiding (controlling) flow of the cooling medium. The guide wall 41 is formed to have a substantially U shape which has an opening toward the first side in the longitudinal direction of the cooling medium flow-passage forming member 11, surrounding the second cooling medium communication port 33, the guide walls 41 being erected on the bottom portion 23a (partition wall) of the lower recess section 23 and adjoining to the fourth heatsink 15.

Accordingly, while the cooling medium flows from the first side (left in FIG. 3) of the cooling medium flow-passage forming member 11 with respect to the longitudinal direction to the second side (right in FIG. 3) with respect to the longitudinal direction in the first cooling space S₁ and the second cooling space S₂, the cooling medium flows from the second side with respect to the longitudinal direction to the first side with respect to the longitudinal direction on the inner side of the guide wall in the third cooling space, and then flows outward with respect to the width direction of the guide wall 41, and from the first side with respect to the longitudinal direction toward the second side with respect to the longitudinal direction on the outer side of the guide wall 41.

Furthermore, as shown in FIGs. 1 to 3, the cooling device 1 is provided with a first swirl generation enhancing member 51, a second swirl generation enhancing member 52, and a third swirl generation enhancing member 53 which generate swirls of the cooling medium in the first cooling space S₁ to the third cooling space S₃. The first swirl generation enhancing member 51 to the third swirl generation enhancing member 53 are rod-shaped members formed to extend in the width direction of the cooling medium flow-passage forming member 11 so as to cross the first cooling space S₁ to the third cooling space S₃, respectively. The first swirl generation enhancing member 51 to the third swirl generation enhancing member 53 have wall surfaces 51a, 52a, 53a extending in a direction that is perpendicular to the flow direction of the cooling medium (the longitudinal direction of the cooling medium flow-passage forming member 11), that is, for instance, in an orthogonal direction (the width direction of the cooling medium flow-passage forming member 11).

Thus, in the first cooling space S₁ to the third cooling space S₃, when the cooling medium hits the first swirl generation enhancing member 51 to the third swirl generation enhancing member 53 (wall surfaces 51a to 53a), the flow direction of the cooling medium is changed, and generation of swirls of the cooling medium is enhanced.

Swirls of the cooling medium cause the cooling medium around the cooling fins 12b to 15b to circulate without being accumulated, so that cooling (heat dissipation) is efficiently performed for the first heatsink 12 to the fourth heatsink 15, i.e., the first member 2 to the fourth member 5.

Herein, as shown in FIG. 3, the first swirl generation enhancing member 51 is disposed substantially in the center of the cooling medium flow-passage forming member 11 with respect to the up-down direction, and spaces D₁, D₂ through each of which the cooling medium flows are disposed between the first swirl generation enhancing member 51 and the first heatsink 12, and between the first swirl generation enhancing member 51 and the second heatsink 13. Furthermore, the second swirl generation enhancing member 52 and the third swirl generation enhancing member 53 are erected on the bottom portion 22a (partition wall) of the upper recess section 22 and a bottom portion 23a (partition wall) of the lower recess section 23, respectively, and spaces D₃, D₄ through each of which the cooling medium flows are disposed between the second swirl generation enhancing member 52 and the third heatsink 14, and between the third swirl generation enhancing member 53 and the fourth heatsink 15. Thus, after hitting the first swirl generation enhancing member 51 to the third swirl generation enhancing member 53 and turning into swirls, the cooling medium passes through the respective spaces D₁ to D₄ and flows downstream.

Furthermore, the first swirl generation enhancing member 51 has a crank-shaped cross section (taken in the direction shown in FIG. 3), and the wall surface 51a of the first swirl generation enhancing member 51 has a step. Herein, the wall surface 51a (first wall surface 51a₁) formed adjacent to the first member 2 (upper side in FIG. 3) is disposed on the most upstream side of the first swirl generation enhancing member 51 with respect to the flow direction of the cooling medium, and the wall surface 51a (second wall surface 51a₂) formed adjacent to the second member 3 (lower side in FIG. 3) is disposed downstream of the first wall surface 51a₁ with respect to the flow direction of the cooling medium.

Thus, in the first cooling space S₁, firstly, the cooling medium hits the first wall surface 51a₁ and thereby generation of swirls of the cooling medium is enhanced in the vicinity of the first heatsink 12 (cooling fin 12b), and then the cooling medium hits the second wall surface 51a₂, and thereby generation of swirls of the cooling medium is enhanced in the vicinity of the second heatsink 13 (cooling fin 13b).

That is, in the first cooling space S₁, generation of swirls is enhanced by the first swirl generation enhancing member 51 at different positions and times, so that the first heatsink 12 (first member 2) is cooled prior to the second heatsink 13 (second member 3) by a slight difference.

With reference to FIGs. 1 and 3, the effect of a cooling device according to an embodiment of the present invention will now be described.

First, the cooling medium is supplied to the first cooling space S₁ via the cooling medium supply port 31 from outside, and flows through the first cooling space S₁ from the first side toward the second side with respect to the longitudinal direction of the cooling medium flow-passage forming member 11 (see FIGs. 1 to 3).

Accordingly, in the first cooling space S₁, the first swirl generation enhancing member 51 enhances generation of swirls of the cooling medium. That is, the cooling medium hits the first wall surface 51a₁ of the first swirl generation enhancing member 51, and thereby generation of swirls of the cooling medium is enhanced in the vicinity of the first heatsink 12 (cooling fin 12b), and then the cooling medium hits the second wall surface 51a₂ of the first swirl generation enhancing member 11, and thereby generation of swirls of the cooling medium is enhanced in the vicinity of the second heatsink 13 (cooling fin 13b) (see FIG. 3). Furthermore, after the first swirl generation enhancing member 51 enhances generation of swirls of the cooling medium, the cooling medium passes through the spaces D₁, D₂ to flow downstream (toward the second side with respect to the longitudinal direction of the cooling medium flow-passage forming member 11).

Next, the cooling medium is supplied to the second cooling space S₂ via the cooling medium communication port 32 from the first cooling space S₁, and flows through the second cooling space S₂ from the first side toward the second side with respect to the longitudinal direction of the cooling medium flow-passage forming member 11 (see FIGs. 1 to 3).

Meanwhile, in the second cooling space S₂, the second swirl generation enhancing member 52 enhances generation of swirls of the cooling medium. That is, the cooling medium hits the second wall surface 52a of the second swirl generation enhancing member 52, and thereby generation of swirls of the cooling medium is enhanced in the vicinity of the third heatsink 14 (cooling fin 14b) (see FIG. 3). Furthermore, after the second swirl generation enhancing member 52 enhances generation of swirls of the cooling medium, the cooling medium passes through the space D₃ to flow downstream (toward the second side with respect to the longitudinal direction of the cooling medium flow-passage forming member 11).

Next, the cooling medium is supplied to the third cooling space S₃ via the second cooling medium communication port 33 from the second cooling space S₂, and flows through the third cooling space S₃ from the second side toward the first side with respect to the longitudinal direction of the cooling medium flow-passage forming member 11, at the inner side of the guide wall 41, then flows outward with respect to the width direction of the guide wall 41, and then flows from the first side toward the second side with respect to the longitudinal direction of the cooling medium flow-passage forming member 11 (see FIGs. 1 to 3).

Meanwhile, in the third cooling space S₃, the third swirl generation enhancing member 53 enhances generation of swirls of the cooling medium, at the inner side and the outer side of the guide wall 41. That is, the cooling medium hits the wall surface 53a of the third swirl generation enhancing member 53, and thereby generation of swirls of the cooling medium is enhanced in the vicinity of the fourth heatsink 15 (cooling fin 15b) at the inner side and the outer side of the guide wall 41 (see FIG. 3). Furthermore, after the third swirl generation enhancing member 53 enhances generation of swirls of the cooling medium, the cooling medium passes through the space D₄ to flow downstream (toward the first side with respect to the longitudinal direction of the cooling medium flow-passage forming member 11 at the inner side of the guide wall 41, toward the second side with respect to the longitudinal direction of the cooling medium flow-passage forming member 11 at the outer side of the guide wall 41).

Next, the cooling medium is discharged outside from the third cooling space S₃ via the cooling medium discharge port 34.

As described above, in the cooling device 1, firstly, the first member 2 (first heatsink 12) and the second member 3 (second heatsink 13) are cooled at the substantially same time, then the third member 4 (third heatsink 14) is cooled, and finally, the fourth member 5 (fourth heatsink 15) is cooled.

In the present embodiment, the cooling device 1 and the first member 2 to the fourth member 5 are to be mounted to an electric vehicle, and the first member 2 to the fourth member 5 are preferably arranged in an order of priority of cooling. Herein, for the plurality of electrical components to be cooled, the order of priority of cooling is determined on the basis of the usage frequency and the amount of heat generation of the electrical components, for instance.

For instance, the first member 2 may be a switching module for a driving motor, which houses an insulated gate bipolar transistor (IGBT) constituting a front motor control unit (FMCU), the second member 3 may be a switching module for a power generator housing an IGBT constituting a generator control unit (GCU), the third member 4 may be a switching module for pressure increase housing an IGBT constituting a voltage control unit (VCU), and the fourth member 5 may include a coil for pressure increase behaving as a reactor.

Furthermore, in the present embodiment, as shown in FIG. 3, a partition wall 42 (member forming the bottom portion 22a, 23a) extends along the flow direction of the cooling medium is disposed between the third heatsink 14 (cooling fin 14b) of the third member 4 and the fourth heatsink 15 (cooling fin 15b) of the fourth member 5, the partition wall 42 dividing the second cooling space S₂ and the third cooling space S₃, and the first cooling medium communication port 32 and the second cooling medium communication port 33 are provided, so that the cooling medium flows through the second cooling space S₂ and then the third cooling space S₃. In other words, the third member 4 attached to the second cooling space S₂ is cooled in priority to the fourth member 5 mounted to the third cooling space S₃.

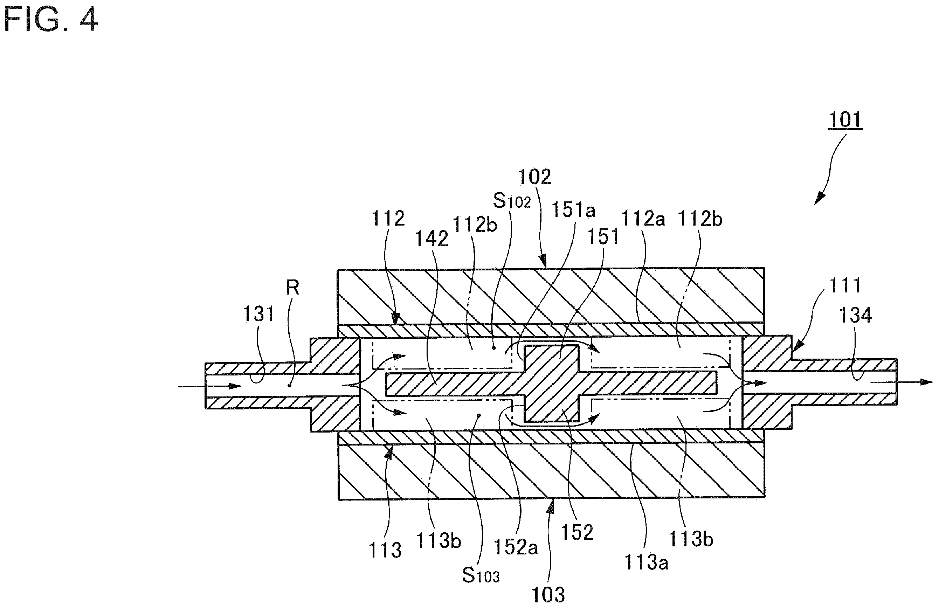

It will be understood that the present invention is not limited to this, and, for instance as shown in FIG. 4, a partition wall 142 may be provided between an upper heatsink 112 of an upper member (first member) 102 and a lower heatsink 113 of a lower member (second member) 103, so as to divide the upper cooling space S₁₀₂ and the lower cooling space S₁₀₃, and a cooling medium supply port (cooling medium supply flow passage) 131 and a cooling medium discharge port 134 that are in communication with both of the cooling spaces S₁₀₂, S₁₀₃ may be provided, so that the cooling medium flows through both of the cooling spaces S₁₀₂, S₁₀₃ at the substantially same time.

With this configuration, it is possible to suppress a large amount of cooling medium flowing through gaps (where the cooling fins 112b, 113b do not exist) between the heatsinks 112, 113, and thereby both of the heatsinks 112, 113 (members 102, 103) are cooled efficiently.

In the cooling device 101 having the above configuration, swirl generation enhancing members 151, 152 may be disposed in the up-down direction of the partition wall 142, respectively, to enhance generation of swirls of the cooling medium in both of the upper and lower spaces of the partition wall 142 (upper cooling space S₁₀₂ and lower cooling space S₁₀₃), thus cooling both of the heatsinks 112, 113 (members 102, 103) even more efficiently.

Furthermore, in the present embodiment, as shown in FIG. 3, the cooling medium flow passage R through which the cooling medium flows is formed by the first heatsink 12 and the third heatsink 14, the second heatsink 13 and the fourth heatsink 15, and the cooling medium flow-passage forming member 11 disposed between the first heatsink 12 to the fourth heatsink 15.

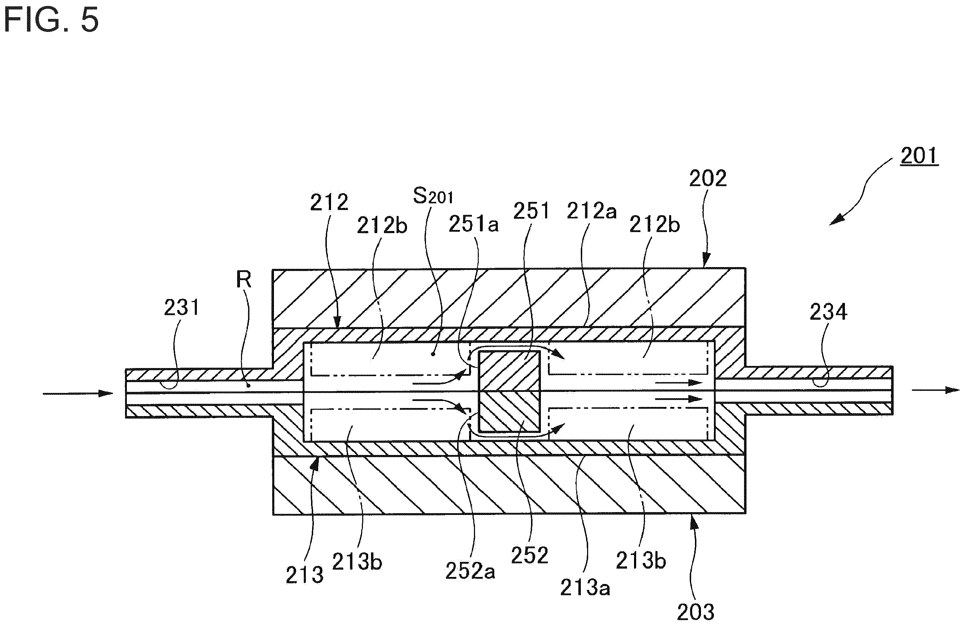

It will be understood that the present invention is not limited to this, and, for instance as shown in FIG. 5, the cooling medium flow passage R may be formed by an upper heatsink 212 disposed on an upper member (first member) 202 and a lower heatsink 213 disposed on a lower member (second member) 203.

With this configuration, it is possible to exert a similar effect to that of an embodiment, while reducing the number of components of the cooling device 201.

In the cooling device 201 having the above configuration, swirl generation enhancing members 251, 252 may be formed by the heatsinks 212, 213, respectively, to enhance generation of swirls of the cooling medium in the cooling medium flow passage R (cooling space S₂₀₁ formed by the heatsinks 212, 213), thus cooling both of the heatsinks 212, 213 (members 202, 203) even more efficiently.

## Claims

1. A cooling device for cooling a first member (2, 4) and a second member (3, 5), the cooling device comprising:
a cooling medium flow passage (R) which is formed between the first member and the second member, and through which a cooling medium for cooling the first member and the second member flows; and
a swirl generation enhancing portion (51, 52, 53) disposed in the cooling medium flow passage and configured to enhance generation of a swirl of the cooling medium flowing therein.

2. The cooling device according to claim 1,
wherein the swirl generation enhancing portion (51, 52, 53) is a wall member having a wall surface (51a, 52a, 53a) extending in a direction which is perpendicular to a flow direction of the cooling medium.

3. The cooling device according to claim 1 or 2,
wherein the swirl generation enhancing portion is disposed so as to have a space (D₁, D₂, D₃, D₄), between itself and the first member and between itself and the second member.

4. The cooling device according to any one of claims 1 to 3,
wherein the swirl generation enhancing portion includes a first wall surface (51a₁) formed on a side of the first member and a second wall surface (51a₂) formed on a side of the second member, and
wherein the first wall surface is disposed upstream of the second wall surface in a flow direction of the cooling medium.

5. The cooling device according to any one of claims 1 to 4, comprising a partition wall (42) extending in a direction along a flow direction of the cooling medium and dividing a first cooling space (S₂) on a side of the first member (4) and a second cooling space (S₃) on a side of the second member (5).

6. The cooling device according to claim 5, comprising a cooling medium supply flow passage (32, 33) for supplying the cooling medium to the first cooling space (S₂) and the second cooling space (S₃).

7. The cooling device according to claim 5, comprising:
a first cooling medium supply flow passage (32) for supplying the cooling medium to the first cooling space (S₂); and
a second cooling medium flow passage (33) for supplying the cooling medium to the second cooling space (S₃) from the first cooling space.

8. The cooling device according to any one of claims 1 to 7,
wherein the first member (2) comprises a first heatsink (12) having a cooling fin (12b) protruding toward the cooling medium flow passage formed thereon, and
wherein the second member (3) comprises a second heatsink (13) having a cooling fin (13b) protruding toward the cooling medium flow passage formed thereon.

9. The cooling device according to claim 8,
wherein the cooling medium flow passage (R) is formed by the first heatsink (12), the second heatsink (13), and a housing (11) disposed between the first heatsink and the second heatsink.

10. The cooling device according to claim 8,
wherein the cooling medium flow passage (R) is formed by the first heatsink (12) and the second heatsink (13).
